(19) Europäisches Patentamt / European Patent Office / Office européen des brevets

(11) **EP 4 682 557 A1**

(12) **EUROPEAN PATENT APPLICATION**
published in accordance with Art. 153(4) EPC

(43) Date of publication:
**21.01.2026 Bulletin 2026/04**

(21) Application number: **24845901.8**

(22) Date of filing: **16.07.2024**

(51) International Patent Classification (IPC):
**G01R 31/36** (2020.01)       **G01R 31/382** (2019.01)
**G01R 31/392** (2019.01)       **G01R 31/396** (2019.01)
**B60L 58/10** (2019.01)

(52) Cooperative Patent Classification (CPC):
**B60L 58/10; G01R 31/36; G01R 31/382;**
**G01R 31/392; G01R 31/396;** Y02E 60/10

(86) International application number:
**PCT/KR2024/010200**

(87) International publication number:
**WO 2025/023598 (30.01.2025 Gazette 2025/05)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **26.07.2023 KR 20230097791**

(71) Applicant: **LG Energy Solution, Ltd.**
**Seoul 07335 (KR)**

(72) Inventors:
• **KIM, Ji-Yeon**
**Daejeon 34122 (KR)**

• **KIM, Young-Deok**
**Daejeon 34122 (KR)**
• **CHOI, Soon-Ju**
**Daejeon 34122 (KR)**
• **KIM, Dae-Soo**
**Daejeon 34122 (KR)**
• **KIM, Tae-Hyeon**
**Daejeon 34122 (KR)**

(74) Representative: **Goddar, Heinz J.**
**Boehmert & Boehmert**
**Anwaltspartnerschaft mbB**
**Pettenkoferstrasse 22**
**80336 München (DE)**

(54) **APPARATUS AND METHOD FOR MANAGING BATTERY**

(57)    A battery management apparatus according to an embodiment of the present disclosure includes a reference information storage unit configured to store a reference capacity information of a reference battery; a capacity information generating unit configured to generate capacity information of each of a plurality of batteries; a characteristic information calculating unit configured to calculate a capacity change ratio that is a ratio of the capacity information and the reference capacity information for each of the plurality of batteries; a calculation processing unit configured to calculate a relative difference of the plurality of capacity change ratios; and a diagnosing unit configured to diagnose a state of the plurality of batteries using a calculation result of the calculation processing unit.

EP 4 682 557 A1

EP 4 682 557 A1

FIG. 1

10

| FIRST BATTERY |

| SECOND BATTERY |

| THIRD BATTERY |

⋮

| kTH BATTERY |

100

BATTERY MANAGEMENT
APPARATUS

120 MEASURING UNIT

130 CAPACITY INFORMATION
GENERATING UNIT

110 REFERENCE INFORMATION
STORAGE UNIT

170 MANAGEMENT
CONTROL UNIT

140 CHARACTERISTIC INFORMATION
CALCULATING UNIT

160 DIAGNOSING UNIT

150 CALCULATION
PROCESSING UNIT

180 INFORMATION
SHARING UNIT

2

## Description

### TECHNICAL FIELD

This application is based on and claims priority from Korean Patent Application No. 10-2023-0097791, filed on July 26, 2023, with the Korean Intellectual Property Office, the disclosure of which is incorporated herein in its entirety by reference.

The present disclosure relates to a technology for diagnosing and managing a state of a battery, and more specifically, to a battery management apparatus and method that effectively diagnoses a defective battery by using a relative comparison of a capacity change ratio.

### BACKGROUND ART

As the demand for portable electronic products such as laptops, video cameras, and mobile phones that use electricity as a power source increases rapidly, and as mobile robots, electric bicycles, electric carts, and electric vehicles become more widely commercialized, research on high-performance secondary batteries capable of repeated charging and discharging is actively being conducted.

Commercialized secondary batteries include nickel-cadmium batteries, nickel hydride batteries, nickel-zinc batteries, and lithium secondary batteries. Among them, lithium secondary batteries have the advantage of being free to charge and discharge and having a very low self-discharge rate compared to nickel-based secondary batteries, with almost no memory effect, and also they have the characteristics of high energy density and high operating voltage, and are therefore being studied more intensively than other types of secondary batteries and are being applied more widely in actual products.

Recently, secondary batteries are widely used not only in small devices such as portable electronic devices, but also in medium and large devices such as electric vehicles and energy storage systems (ESSs).

In this case, a battery module in which a number of electrically connected secondary batteries are stored together inside a module case is mainly applied. Furthermore, in cases where high power or large capacity is required, a battery pack in which a number of such battery modules are electrically connected is also applied.

Secondary battery cells, cell assemblies, battery modules, or battery packs (hereinafter collectively referred to as 'batteries') are important factors for power efficiency and safety. Accordingly, research is also actively being conducted on BMS (Battery Management System), which monitors the electrical characteristics of the battery and performs feedback control such as charging and discharging using the monitoring results.

Unlike the method of generating energy based on fossil fuels, secondary cell-based batteries generate energy through electrochemical reactions, so there is a problem in that they cannot maintain the performance of the BOL (Beginning Of Life) state as the charging and discharging cycle progresses.

This degradation phenomenon is an inherent phenomenon that occurs as the battery is used, but it can also be affected by manufacturing defects such as process errors, impurity contamination, physical damage (cracks, etc.), and short circuits.

In this way, as the battery continues to be used (charged and discharged), its usability decreases due to capacity deterioration, output deterioration, etc., and such deterioration also acts as a risk factor in terms of safety. Therefore, in order to control the limited use of degraded batteries, determine the replacement timing, or improve the efficiency of battery reuse (or recycling), it is necessary to accurately and quickly diagnose the current battery degradation level and whether it is defective.

### DISCLOSURE

### Technical Problem

The present disclosure is designed to solve the problems of the related art, and therefore the present disclosure is directed to providing a battery management apparatus and method that may quickly and accurately diagnose and select a defective battery by using information about a capacity change (capacity change ratio) of each of a plurality of batteries and a relative difference value between them.

The technical problems that the present disclosure seeks to solve are not limited to the problems described above, and other problems that are not mentioned will be clearly understood by those skilled in the art from the description of the invention described below.

### Technical Solution

A battery management apparatus according to one aspect of the present disclosure may comprise: a reference information storage unit configured to store a reference capacity information of a reference battery; a capacity information generating unit configured to generate capacity information of each of a plurality of batteries; a characteristic information calculating unit configured to calculate a capacity change ratio that is a ratio of the capacity information and the reference capacity information for each of the plurality of batteries; a calculation processing unit configured to calculate a relative difference of the plurality of capacity change ratios; and a diagnosing unit configured to diagnose a state of the plurality of batteries using a calculation result of the calculation processing unit.

The diagnosing unit may be configured to diagnose a normal battery and a defective battery among the plurality of batteries using the calculation result.

The battery management apparatus according to another aspect of the present disclosure may further comprise a management control unit configured to control charging and discharging of the defective battery to be limited.

The diagnosing unit may be configured to generate degradation rate information for at least one battery among the plurality of batteries using the calculation result.

The battery management apparatus according to still another aspect of the present disclosure may further comprise a management control unit configured to control at least one battery among the plurality of batteries so that charging and discharging ranges are differentially limited according to the degradation rate information.

The calculation processing unit may be configured to perform weight calculation on a difference calculation result between an average value of the plurality of capacity change ratios and an individual capacity change ratio.

The calculation processing unit may be configured to calculate a statistical deviation value of the plurality of capacity change ratios.

The diagnosing unit may be configured to further diagnose a degradation imbalance of the plurality of batteries using the statistical deviation value.

The characteristic information calculating unit may be configured to calculate a ratio of the capacity information to the reference capacity information as the capacity change ratio.

A battery pack according to still another aspect of the present disclosure may comprise the battery management apparatus according to an aspect of the present disclosure.

A vehicle according to still another aspect of the present disclosure may comprise the battery management apparatus according to an aspect of the present disclosure.

A battery management method according to still another aspect of the present disclosure may comprise: a reference information storing step of storing reference capacity information of a reference battery; a capacity information generating step of generating capacity information of each of a plurality of batteries; a characteristic information calculating step of calculating a capacity change ratio that is a ratio of the capacity information and the reference capacity information for each of the plurality of batteries; a calculation processing step of calculating a relative difference of the plurality of capacity change ratios; and a diagnosing step of diagnosing a state of the plurality of batteries using a calculation result of the calculation processing step.

Advantageous Effects

According to the present disclosure, there is an advantage in that a defective battery may be quickly diagnosed from a plurality of batteries based on data relating to capacity decrease. In addition, according to the present disclosure, degradation rate information of the defective battery may be quickly and accurately provided.

In addition, since the diagnostic method by the present disclosure may be implemented through software that can be installed in BMS, etc. or a module that executes the same, it is possible to provide higher expandability.

According to one aspect of the present disclosure, since it is possible to accurately diagnose whether an object (e.g., a battery pack) applied to an actual application device (e.g., a vehicle, ESS, etc.) is degraded and/or whether degradation imbalance is present, the effectiveness of battery control and management may be improved.

In addition, in the case of the present disclosure, the efficiency of battery management processing may be further improved by differentially applying the usage restriction range of a plurality of batteries according to the capacity change ratio or the degradation rate information.

DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.

FIG. 1 is a block diagram illustrating a detailed configuration of a battery management apparatus according to an embodiment of the present disclosure.
FIG. 2 is a flow chart illustrating a processing process according to an embodiment of the present disclosure.
FIG. 3 is a flow chart illustrating a processing process according to another embodiment of the present disclosure.
FIG. 4 is a drawing showing an example of a Q-V profile for a target battery.
FIG. 5 is a drawing comparing the Q-V profiles of a reference battery and a target battery.
FIG. 6 is a drawing explaining a first embodiment of a capacity change ratio for each of a plurality of batteries.
FIG. 7 is a drawing explaining a second embodiment of a capacity change ratio for each of a plurality of batteries.
FIG. 8 is a drawing explaining an example of a distribution of deviation values generated using a capacity change ratio.

BEST MODE

Hereinafter, preferred embodiments of the present disclosure will be described in detail with reference to the accompanying drawings. Prior to the description, it should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

Throughout the specification, when a portion is referred to as "comprising" or "including" any element, it means that the portion may include other elements further, without excluding other elements, unless specifically stated otherwise.

Additionally, terms such as processor described in the specification mean a unit that processes at least one function or operation, which may be implemented by hardware, software, or a combination of hardware and software.

In addition, throughout the specification, when a portion is referred to as being "connected" to another portion, it is not limited to the case that they are "directly connected", but it also includes the case where they are "indirectly connected" with another element being interposed between them.

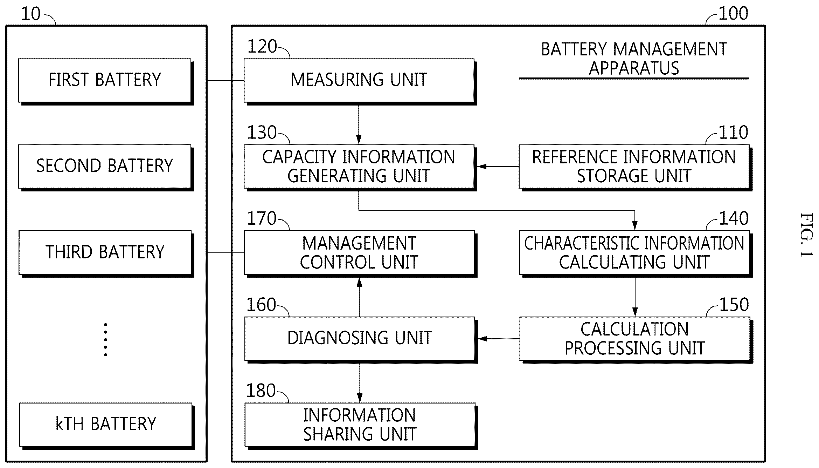

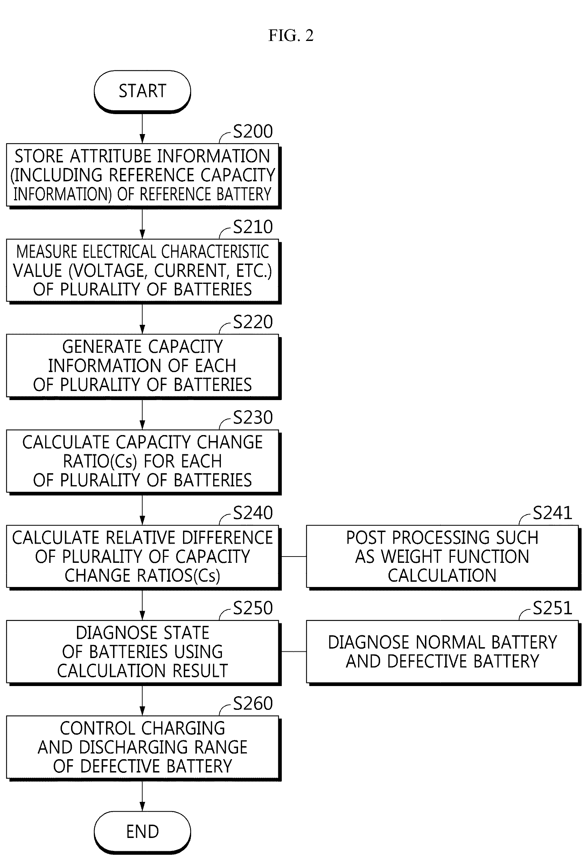

FIG. 1 is a block diagram illustrating a detailed configuration of a battery management apparatus 100 according to an embodiment of the present disclosure, and FIG. 2 is a flow chart illustrating a processing process according to an embodiment of the present disclosure.

As illustrated in FIG. 1, the battery management apparatus 100 of the present disclosure may be configured to include a reference information storage unit 110, a measuring unit 120, a capacity information generating unit 130, a characteristic information calculating unit 140, a calculation processing unit 150, a diagnosing unit 160, a management control unit 170, and an information sharing unit 180.

Before going into the detailed description of the present disclosure, the battery management apparatus 100 according to the present disclosure may be implemented through various combinational applications of electronic devices, parts, etc., such as storage means, calculation processing means, input/output means, etc. Therefore, each component of the battery management apparatus 100 illustrated in FIG. 1 should be understood as a functionally or logically distinct component rather than a physically distinct component.

That is, since each component depicted in the drawing corresponds to a logical structure for effectively explaining the technical idea by the present disclosure, even if each component is configured integrated or separately, if the function performed by the logical structure of the present disclosure can be realized, it should be interpreted as being within the scope of the present disclosure, and if it is a component that performs the same or similar function, it should of course be interpreted as being within the scope of the present disclosure regardless of the consistency in their names.

In addition, the battery diagnosis or management method by the present disclosure may be implemented as a set or algorithm of processing for data processing, handling, control, operation, input/output, etc., and thus, it may be implemented by a combination of logical structures shown in FIG. 1, as well as in the form of software that is installed and operated in a system, device, computer (or a device equivalent thereto), BMS, module, or lower-level components thereof.

The battery management apparatus 100 of the present disclosure may be configured to detect or diagnose a normal battery and a defective battery by targeting a plurality of batteries 10. According to an embodiment, the battery management apparatus 100 may be configured to generate and output diagnostic data for a plurality of batteries 10 for organic linkage with other configurations or modules/devices.

Here, the defective battery BB refers to a battery that has a relatively high degree of degradation compared to other batteries or cannot exhibit the designed operating performance due to process errors, physical damage, etc.

From a corresponding perspective, the normal battery NB refers to a battery that has the opposite characteristics to the defective battery BB, and has driving performance (degradation level, etc.) at the same or similar level as other batteries. Alternatively, the normal battery NB refers to a battery that implements normal driving performance (taking into account the range of errors) corresponding to the designed specifications. Here, normal driving performance does not mean driving performance of the BOL (Beginning Of Life) state, but rather may mean driving performance that is expressed at a level of degradation within the normal range according to the number of times or degree of use while going through a normal degradation process.

For example, in the embodiment of FIG. 1, the battery management apparatus 100 may diagnose and manage a plurality of batteries 10. For example, the battery management apparatus 100 may diagnose and manage k batteries, where k is a natural number greater than or equal to 2.

Also, in FIG. 1, the plurality of batteries 10 may be a single cell or a cell assembly having a plurality of cells connected in series and/or in parallel.

The measuring unit 120 is configured to measure electrical characteristic values (voltage, current, temperature, resistance, etc.) of a battery that is a target of diagnosis (hereinafter referred to as 'target battery') during a charging or discharging process (S210).

When the electrical characteristic value of the target battery is measured in this way, the capacity information generating unit 130 of the present disclosure is configured to generate capacity information of each of the plurality of batteries 10 using the measured electrical characteristic values (voltage, current, temperature, resistance, charge/discharge rate (C-rate), etc.) (S220).

If the capacity information is generated during the charging process, the capacity information may be a completely charged capacity according to the full charge of the battery, and if the capacity information is generated during the discharging process, the capacity information may be a completely discharged capacity of the battery according to the full discharge.

The capacity information is information or data that may represent the performance or degradation level of a battery, and has a behavioral characteristic that decreases depending on the number of times the battery is used, the charge/discharge conditions, the usage environment, etc., and may be generated through various methods such as estimation based on the voltage increase rate, the current integration method, and comparison of a reference profile and a charge/discharge profile.

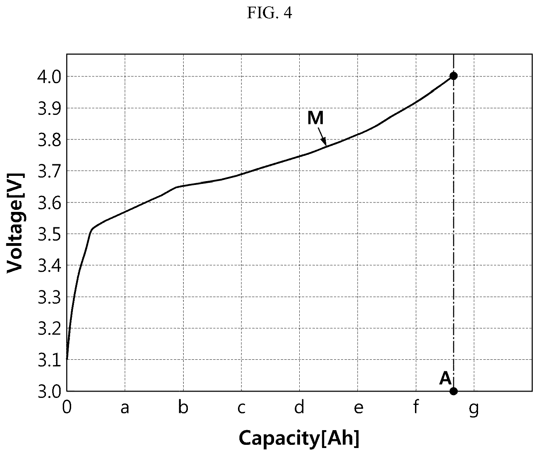

FIG. 4 is a diagram illustrating an example of a Q-V profile M representing the relationship between an electrical characteristic value (voltage, V) generated for a target battery and capacity information estimated or generated to correspond thereto. Here, the Q-V profile M is a profile representing the corresponding relationship between the capacity and voltage of the target battery.

The Q-V profile of FIG. 4 is a profile generated during the charging process, and the capacity (Ah or mAh) at the point marked as A in FIG. 4 corresponds to the capacity information according to the full charge of the target battery, i.e., the capacity information. FIG. 4 is only intended to increase the convenience of understanding and the efficiency of explanation, so it goes without saying that the capacity information may be generated in the form of quantitative data, such as numbers, without a process of generating the entire profile as in FIG. 4 using graphic elements, etc.

When the capacity information of the target battery is generated, the characteristic information calculating unit 140 generates a capacity change ratio (Cs), which is a ratio of the capacity information and reference capacity information, for each of the plurality of batteries 10 (S230).

Here, the reference battery is a battery having dimensions or specifications equivalent to those of the battery to be diagnosed, and may be a battery in the BOL (Beginning Of Life) state or a simulated ideal battery for relative comparison with the target battery. The reference capacity information is capacity information of the reference battery, and may be stored in advance (S200) in the reference information storage unit 110 of the present disclosure, etc., depending on the embodiment.

The capacity change ratio (Cs) may be a ratio or equivalent information between the reference capacity information of the reference battery and the capacity information of the target battery, as shown in the formula below.

[Formula 1]

$$Cs = \frac{Q_T}{Q_R} \times 100(\%)$$

In Formula 1, $Q_T$ is the capacity information of the target battery, and $Q_R$ is the reference capacity information of the reference battery. That is, the characteristic information calculating unit 140 may calculate the ratio of the capacity information ($Q_T$) to the reference capacity information ($Q_R$) as the capacity change ratio (Cs).

The capacity change ratio (Cs) is for the relative contrast between the reference capacity information and the capacity information of the target battery based on the current point in time, so it goes without saying that the parameters set in the numerator and denominator of Formula 1 may be configured in reverse depending on the embodiment.

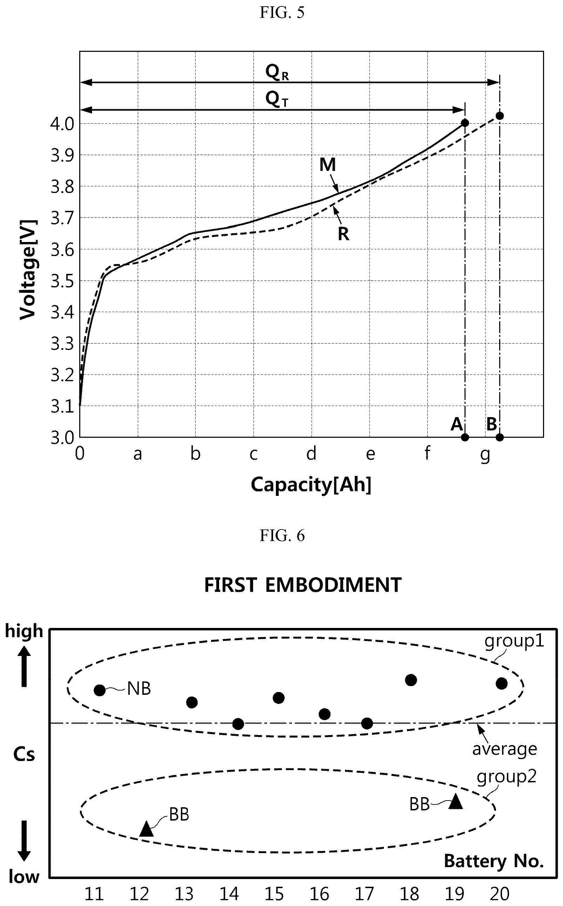

As illustrated in FIG. 5, which is a drawing comparing the Q-V profile R of the reference battery and the Q-V profile M of the target battery, the reference capacity information ($Q_R$) may be the capacity of a point indicated as "B" in FIG. 5, and the capacity information ($Q_T$) may be the capacity of a point indicated as "A" in FIG. 5.

According to Formula 1, the capacity change ratio (Cs) of the reference battery is 100%, and as aging or degradation increases, the decrease in capacity increases, so the numerical value of the capacity change ratio (Cs) gradually decreases. If the numerator and denominator of Formula 1 are configured in reverse to define the capacity change ratio (Cs), the capacity change ratio (Cs) of the target battery with severe aging becomes larger than the capacity change ratio (Cs) of the target battery with relatively little aging.

As described above, the electrode change ratio (Cs) is an indicator representing the degree of degradation of the target battery. As the degree of degradation increases, its size decreases. Therefore, the size of the electrode change ratio (Cs) itself (based on Formula 1) may be an important parameter for diagnosing the degree of degradation of the target battery.

As described above, batteries applied to application devices (electric vehicles, ESS, etc.) are generally formed in the form where a plurality of batteries 10 are grouped as exemplified in FIG. 1. If there is a large deviation in the degree of aging among the grouped batteries, collective performance degradation may occur in which the overall performance of the grouped batteries is degraded to the level of the battery with the most severe performance degradation.

In this respect, it is desirable to configure a defective battery BB to be selected among the plurality of batteries 10 based on the relative difference in degradation degree, namely the relative difference in in the capacity change ratio (Cs), so the calculation processing unit 150 may be configured to calculate the relative difference in the plurality of capacity change ratios (Cs) (S240).

As a method for calculating the relative difference, a method for relatively comparing the capacity change ratio (Cs) itself may be applied. Also, a method for calculating the difference between an average value of the plurality of capacity change ratios (Cs) and an individual capacity change ratio (Cs), or a method for functionally calculating a weight proportional to the size of the different calculation result on the difference calculation result may be applied (S241).

When this weight calculation is applied, it is possible to provide the advantage of more clearly distinguishing normal batteries NB whose capacity change ratio (Cs) falls within the average value range and defective batteries BB whose capacity change ratio (Cs) falls outside the average value range.

When the relative difference of the plurality of capacity change ratios (Cs) is calculated in this way (S240), the diagnosing unit 160 diagnoses the state of the plurality of batteries 10 using the calculation result of the calculation processing unit 150 (S250).

FIG. 6 is a drawing explaining a first embodiment of the capacity change ratio (Cs) for each of a plurality of batteries. Specifically, FIG. 6 is a drawing explaining the first embodiment of the capacity change ratio (Cs) for 10 batteries with reference numbers 11 to 20.

In the embodiment of FIG. 6, the batteries (reference numbers 12, 19) included in group 2 exhibit relatively low capacity change ratios (Cs) compared to the batteries (reference numbers 11, 13-18, 20) included in group 1. Therefore, the diagnosing unit 160 may diagnose the batteries (reference numbers 12, 19) included in group 2 as defective batteries BB (S251). In addition, the capacity change ratio (Cs) of the batteries (reference numbers 11, 13-18, 20) included in group 1 form a distribution with small deviations based on the average value. Therefore, the diagnosing unit 160 may diagnose the batteries (reference numbers 11, 13-18, 20) included in group 1 as normal batteries NB (S251).

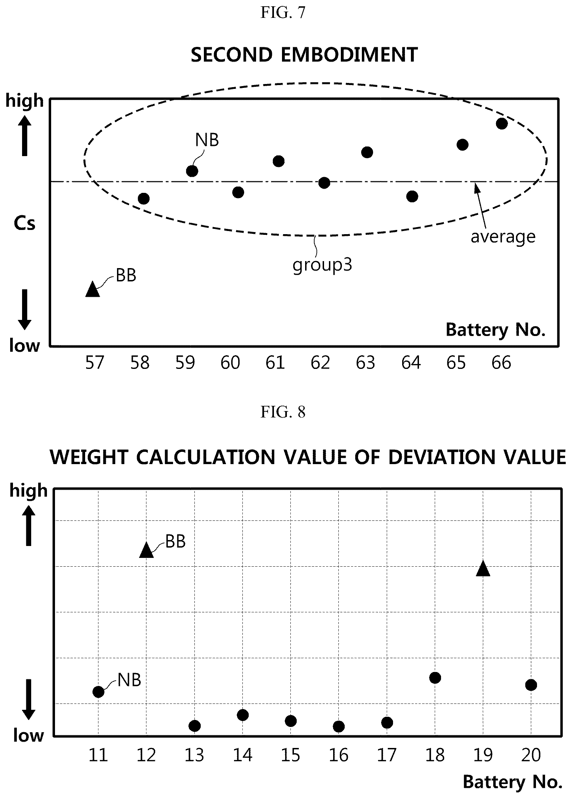

FIG. 7 is a drawing explaining a second embodiment of the capacity change ratio (Cs) for each of a plurality of batteries. Specifically, FIG. 7 is a drawing explaining the second embodiment of the capacity change ratio (Cs) for 10 batteries with reference numbers 57 to 66.

In the case of FIG. 7, only battery No. 57 has a capacity change ratio (Cs) that is relatively different from those of other batteries (reference numbers 58-66).

Therefore, the diagnosing unit 160 may diagnose battery No. 57 as a defective battery BB, and all batteries (reference numbers 58-66) included in group 3 may be diagnosed as normal batteries NB.

FIG. 8 is a diagram illustrating the result of performing weight calculation (square of difference calculation result value) on the difference calculation result between the average value of the plurality of plurality of capacity change ratios (Cs) and individual plurality of capacity change ratios (Cs) based on the plurality of capacity change ratios (Cs) of the plurality of batteries illustrated in FIG. 6.

Referring to FIG. 8, when a weight calculation such as the square of the deviation value (the difference calculation between the average value of the capacity change ratios and the individual capacity change ratios) or an exponential function (e.g., $f(x) = 2^x$, where x is the deviation value (absolute value)) is performed, the value of the defective battery BB may be more clearly expressed in contrast to the value of the normal battery NB, so that the resolution for distinguishing the defective battery BB may be implemented more precisely.

When a defective battery BB is diagnosed by the diagnosing unit 160, the management control unit 170 may exclude the defective battery BB from the charging and discharging processing or control the charging and discharging of the defective battery BB to be limited to a specific range (S260).

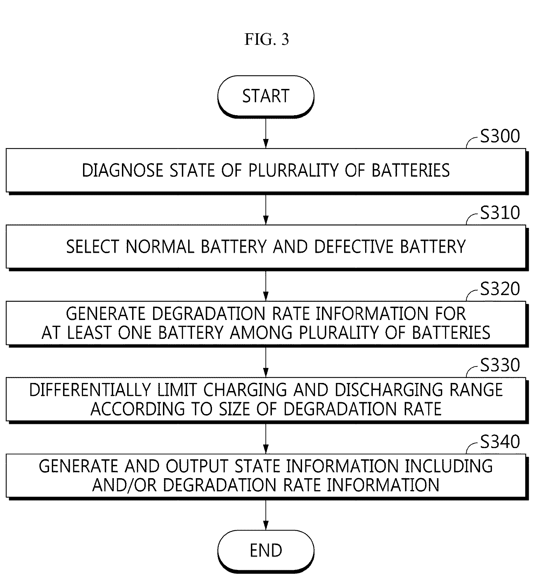

FIG. 3 is a flow chart illustrating a processing process according to another embodiment of the present disclosure.

As described above, when the state of a plurality of batteries is diagnosed (S300) and a normal battery NB and a defective battery BB are selected accordingly (S310), the diagnosing unit 160 may be configured to generate degradation rate information of the defective battery BB using a capacity change ratio (Cs) (S320).

When the degradation rate information of a defective battery BB, etc. is generated and input to the management control unit 170, the management control unit 170 may limit the charging and discharging range of the defective battery BB. Also, the management control unit 170 may control the charging and discharging range of the defective battery BB to be differentially limited according to the degradation rate information, such as by making the limitation of the charging and discharging range relatively large in the case of a defective battery BB having relatively large degradation rate information (S330).

According to an embodiment, the reference information storage unit 110 may be configured to further store identification information of the plurality of batteries 10 and/or attribute information including the identification information of the batteries 10.

In this case, the information sharing unit 180 may be configured to generate the identification information of the plurality of batteries 10 and state information of the corresponding batteries including defect information, or degradation rate information and output them to a user terminal or an info system of a vehicle (S340).

Furthermore, when the plurality of capacity change ratios (Cs) of the plurality of batteries 10 are generated as described above, the calculation processing unit 150 may calculate the statistical deviation value (variance value, standard deviation value, etc.) of the plurality of capacity change ratios (Cs).

Since the statistical deviation value is generated using the capacity change ratio (Cs) of each of the plurality of batteries 10, this statistical deviation value becomes information representing the properties of the plurality of batteries 10.

When a statistical deviation value is generated in this way, the diagnosing unit 160 may additionally diagnose the degradation imbalance of the plurality of batteries 10 using this statistical deviation value.

A relatively large statistical deviation value (compared to the reference value, etc.) means that there is a large deviation in the degradation of the plurality of batteries 10. In other words, a relatively large statistical deviation value means that the degradation among the plurality of batteries 10 is not balanced or uniform. Conversely, a relatively small statistical deviation value means that the degradation of the plurality of batteries 10 is uniform.

In this way, in the case of the present disclosure, the presence and degree of degradation imbalance of upper aggregates such as packs or modules are diagnosed, so subsequent processing or operations such as restricted use targeting packs or modules, exclusion of charging and discharging, and determination of replacement time may be more effectively induced.

In addition, the battery management apparatus 100 according to the present disclosure may be applied to a BMS (Battery Management System). That is, the BMS according to the present disclosure may include the battery management apparatus 100 described above. In this configuration, at least some of the components of the battery management apparatus 100 may be implemented by supplementing or adding functions of the configuration included in the conventional BMS.

The battery management apparatus 100 according to the present disclosure may be provided in a battery pack. That is, the battery pack according to the present disclosure may include the above-described battery management apparatus 100 and a plurality of batteries 10 or the like.

Furthermore, the battery management apparatus 100 according to the present disclosure may be equipped in a vehicle such as an electric vehicle or a hybrid vehicle. That is, the vehicle according to the present disclosure may include the battery management apparatus according to the present disclosure or the battery pack according to the present disclosure. In addition, the vehicle according to the present disclosure may further include various other components included in the vehicle in addition to the battery management apparatus or the battery pack. For example, the vehicle according to the present disclosure may further include a body, a motor, a control device such as an ECU (electronic control unit), etc. in addition to the apparatus according to the present disclosure.

The present disclosure has been described in detail. However, the detailed description and specific examples, while indicating preferred embodiments of the disclosure, are given by way of illustration only, since various changes and modifications within the scope of the disclosure will become apparent to those skilled in the art from this detailed description.

The attached drawings, etc. for the purpose of explaining the present disclosure and illustrating examples thereof may be illustrated in a somewhat exaggerated form in order to emphasize or highlight the technical content of the present disclosure. However, it should be interpreted that it is obvious that various modified application examples are possible at the level of a person skilled in the art by considering the previously described content and matters illustrated in the drawings.

In addition, it is self-evident that expressions such as first, second, upper, lower, or superior and inferior in the explanation of the present disclosure are merely instrumental concept terms used to relatively distinguish each component (element) from each other, and are not terms used to indicate a specific order, priority, etc., or terms used to physically distinguish each component (element) on an absolute basis.

(Explanation of reference signs)

10: plurality of battery
100: battery management apparatus
110: reference information storage unit
120: measuring unit
130: capacity information generating unit
140: characteristic information calculating unit
150: calculation processing unit
160: diagnosing unit
170: management control unit
180: information sharing unit

## Claims

1. A battery management apparatus, comprising:

a reference information storage unit configured to store a reference capacity information of a reference battery;
a capacity information generating unit configured to generate capacity information of each of a plurality of batteries;
a characteristic information calculating unit configured to calculate a capacity change ratio that is a ratio of the capacity information and the reference capacity information for each of the plurality of batteries;

a calculation processing unit configured to calculate a relative difference of the plurality of capacity change ratios; and

a diagnosing unit configured to diagnose a state of the plurality of batteries using a calculation result of the calculation processing unit.

2. The battery management apparatus according to claim 1,
wherein the diagnosing unit is configured to diagnose a normal battery and a defective battery among the plurality of batteries using the calculation result.

3. The battery management apparatus according to claim 2, further comprising:
a management control unit configured to control charging and discharging of the defective battery to be limited.

4. The battery management apparatus according to claim 1,

wherein the diagnosing unit is configured to generate degradation rate information for at least one battery among the plurality of batteries using the calculation result, and
wherein the battery management apparatus further comprises a management control unit configured to control at least one battery among the plurality of batteries so that charging and discharging ranges are differentially limited according to the degradation rate information.

5. The battery management apparatus according to claim 1,
wherein the calculation processing unit is configured to perform weight calculation on a difference calculation result between an average value of the plurality of capacity change ratios and an individual capacity change ratio.

6. The battery management apparatus according to claim 1,

wherein the calculation processing unit is configured to calculate a statistical deviation value of the plurality of capacity change ratios, and
wherein the diagnosing unit is configured to further diagnose a degradation imbalance of the plurality of batteries using the statistical deviation value.

7. The battery management apparatus according to claim 1,
wherein the characteristic information calculating unit is configured to calculate a ratio of the capacity information to the reference capacity information as the capacity change ratio.

8. A battery pack, comprising the battery management apparatus according to any one of claims 1 to 7.

9. A vehicle, comprising the battery management apparatus according to any one of claims 1 to 7.

10. A battery management method, comprising:

a reference information storing step of storing reference capacity information of a reference battery;
a capacity information generating step of generating capacity information of each of a plurality of batteries;
a characteristic information calculating step of calculating a capacity change ratio that is a ratio of the capacity information and the reference capacity information for each of the plurality of batteries;
a calculation processing step of calculating a relative difference of the plurality of capacity change ratios; and
a diagnosing step of diagnosing a state of the plurality of batteries using a calculation result of the calculation processing step.

FIG. 1

Battery Management Apparatus (100):
- Reference Information Storage Unit (110)
- Characteristic Information Calculating Unit (140)
- Calculation Processing Unit (150)
- Measuring Unit (120)
- Capacity Information Generating Unit (130)
- Management Control Unit (170)
- Diagnosing Unit (160)
- Information Sharing Unit (180)

Batteries (10):
- First Battery
- Second Battery
- Third Battery
- ·····
- kTH Battery

FIG. 2

```
                        ┌─────────────┐
                        │    START    │
                        └──────┬──────┘
                               │           ⌐S200
        ┌──────────────────────▼──────────────────┐
        │ STORE ATTRITUBE INFORMATION              │
        │ (INCLUDING REFERENCE CAPACITY            │
        │ INFORMATION) OF REFERENCE BATTERY        │
        └──────────────────────┬──────────────────┘
                               │           ⌐S210
        ┌──────────────────────▼──────────────────┐
        │ MEASURE ELECTRICAL CHARACTERISTIC        │
        │ VALUE (VOLTAGE, CURRENT, ETC.)           │
        │ OF PLURALITY OF BATTERIES                │
        └──────────────────────┬──────────────────┘
                               │           ⌐S220
        ┌──────────────────────▼──────────────────┐
        │         GENERATE CAPACITY                │
        │         INFORMATION OF EACH              │
        │       OF PLURALITY OF BATTERIES          │
        └──────────────────────┬──────────────────┘
                               │           ⌐S230
        ┌──────────────────────▼──────────────────┐
        │    CALCULATE CAPACITY CHANGE             │
        │       RATIO(Cs) FOR EACH                 │
        │    OF PLURALITY OF BATTERIES             │
        └──────────────────────┬──────────────────┘
                               │           ⌐S240
        ┌──────────────────────▼──────────────────┐
        │ CALCULATE RELATIVE DIFFERENCE            │
        │ OF PLURALITY OF CAPACITY                 │
        │ CHANGE RATIOS(Cs)                        │
        └──────────────────────┬──────────────────┘
                               │           ⌐S250
        ┌──────────────────────▼──────────────────┐
        │        DIAGNOSE STATE                    │
        │        OF BATTERIES USING                │
        │        CALCULATION RESULT                │
        └──────────────────────┬──────────────────┘
                               │           ⌐S260
        ┌──────────────────────▼──────────────────┐
        │       CONTROL CHARGING                   │
        │    AND DISCHARGING RANGE                 │
        │      OF DEFECTIVE BATTERY                │
        └──────────────────────┬──────────────────┘
                               │
                        ┌──────▼──────┐
                        │     END     │
                        └─────────────┘
```

S241
POST PROCESSING SUCH
AS WEIGHT FUNCTION
CALCULATION

S251
DIAGNOSE NORMAL BATTERY
AND DEFECTIVE BATTERY

FIG. 3

```
          ┌─────────┐
          │  START  │
          └─────────┘
               │
               ▼                                    ┌─S300
┌──────────────────────────────────────────────────────┐
│      DIAGNOSE STATE OF PLURRALITY OF BATTERIES         │
└──────────────────────────────────────────────────────┘
               │                                    ┌─S310
               ▼
┌──────────────────────────────────────────────────────┐
│     SELECT NORMAL BATTERY AND DEFECTIVE BATTERY        │
└──────────────────────────────────────────────────────┘
               │                                    ┌─S320
               ▼
┌──────────────────────────────────────────────────────┐
│       GENERATE DEGRADATION RATE INFORMATION FOR        │
│   AT LEAST ONE BATTERY AMONG PLURALITY OF BATTERIES    │
└──────────────────────────────────────────────────────┘
               │                                    ┌─S330
               ▼
┌──────────────────────────────────────────────────────┐
│ DIFFERENTIALLY LIMIT CHARGING AND DISCHARGING RANGE    │
│       ACCORDING TO SIZE OF DEGRADATION RATE            │
└──────────────────────────────────────────────────────┘
               │                                    ┌─S340
               ▼
┌──────────────────────────────────────────────────────┐
│  GENERATE AND OUTPUT STATE INFORMATION INCLUDING       │
│      AND/OR DEGRADATION RATE INFORMATION               │
└──────────────────────────────────────────────────────┘
               │
               ▼
          ┌─────────┐
          │   END   │
          └─────────┘
```

FIG. 4

FIG. 5

FIG. 6

## FIRST EMBODIMENT

FIG. 7

## SECOND EMBODIMENT

FIG. 8

## WEIGHT CALCULATION VALUE OF DEVIATION VALUE

## INTERNATIONAL SEARCH REPORT

| International application No. |
|---|
| **PCT/KR2024/010200** |

| **A.** | **CLASSIFICATION OF SUBJECT MATTER** |
|---|---|
| | **G01R 31/36**(2006.01)i; **G01R 31/382**(2019.01)i; **G01R 31/392**(2019.01)i; **G01R 31/396**(2019.01)i; **B60L 58/10**(2019.01)i |

According to International Patent Classification (IPC) or to both national classification and IPC

| **B.** | **FIELDS SEARCHED** |
|---|---|

Minimum documentation searched (classification system followed by classification symbols)

G01R 31/36(2006.01); B60L 11/18(2006.01); H01M 10/48(2006.01); H02J 7/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 용량(capacity), 기준(reference), 퇴화(degradation), 비율(ratio)

| **C.** | **DOCUMENTS CONSIDERED TO BE RELEVANT** | |
|---|---|---|
| Category* | Citation of document, with indication, where appropriate, of the relevant passages | Relevant to claim No. |
| Y | KR 10-2019-0073065 A (LG CHEM, LTD.) 26 June 2019 (2019-06-26)<br>See paragraphs [0028]-[0035]; claims 1-3; and figure 1. | 1-10 |
| Y | KR 10-2022-0036701 A (LG ENERGY SOLUTION, LTD.) 23 March 2022 (2022-03-23)<br>See paragraphs [0042]-[0097]; claims 1-7; and figures 1-5. | 1-10 |
| A | KR 10-2015-0048439 A (HYUNDAI MOBIS CO., LTD.) 07 May 2015 (2015-05-07)<br>See paragraphs [0031]-[0068]; claims 1-10; and figures 1-4. | 1-10 |
| A | US 2017-0259687 A1 (FORD GLOBAL TECHNOLOGIES, LLC.) 14 September 2017 (2017-09-14)<br>See paragraphs [0030]-[0067]; claims 1-19; and figures 1-6. | 1-10 |
| A | WO 2017-130258 A1 (PANASONIC INTELLECTUAL PROPERTY MANAGEMENT CO., LTD.) 03 August 2017 (2017-08-03)<br>See paragraphs [0011]-[0054]; claims 1-6; and figures 1-13. | 1-10 |

☐ Further documents are listed in the continuation of Box C.  ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **28 October 2024** | **28 October 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

INTERNATIONAL SEARCH REPORT
Information on patent family members

International application No.

**PCT/KR2024/010200**

| Patent document cited in search report | | | Publication date (day/month/year) | Patent family member(s) | | | Publication date (day/month/year) |
|---|---|---|---|---|---|---|---|
| KR | 10-2019-0073065 | A | 26 June 2019 | CN | 110679056 | A | 10 January 2020 |
| | | | | CN | 110679056 | B | 09 May 2023 |
| | | | | EP | 3641095 | A1 | 22 April 2020 |
| | | | | EP | 3641095 | A4 | 03 June 2020 |
| | | | | EP | 3641095 | B1 | 19 October 2022 |
| | | | | JP | 2020-518965 | A | 25 June 2020 |
| | | | | JP | 7020706 | B2 | 16 February 2022 |
| | | | | KR | 10-2259967 | B1 | 02 June 2021 |
| | | | | US | 11397217 | B2 | 26 July 2022 |
| | | | | US | 2020-0182943 | A1 | 11 June 2020 |
| | | | | WO | 2019-124738 | A1 | 27 June 2019 |
| KR | 10-2022-0036701 | A | 23 March 2022 | | None | | |
| KR | 10-2015-0048439 | A | 07 May 2015 | CN | 104569827 | A | 29 April 2015 |
| | | | | CN | 104569827 | B | 27 October 2017 |
| | | | | KR | 10-2080632 | B1 | 14 April 2020 |
| US | 2017-0259687 | A1 | 14 September 2017 | CN | 107176038 | A | 19 September 2017 |
| | | | | CN | 107176038 | B | 19 August 2022 |
| | | | | DE | 102017103730 | A1 | 14 September 2017 |
| | | | | US | 9840161 | B2 | 12 December 2017 |
| WO | 2017-130258 | A1 | 03 August 2017 | CN | 107923949 | A | 17 April 2018 |
| | | | | CN | 107923949 | B | 09 July 2021 |
| | | | | EP | 3410136 | A1 | 05 December 2018 |
| | | | | EP | 3410136 | A4 | 16 January 2019 |
| | | | | EP | 3410136 | B1 | 02 February 2022 |
| | | | | JP | 6751915 | B2 | 09 September 2020 |
| | | | | US | 10493848 | B2 | 03 December 2019 |
| | | | | US | 2019-0077265 | A1 | 14 March 2019 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230097791